Europäisches Patentamt

(19) European Patent Office

Office européen des brevets

(11) Publication number : **0 336 951 B1**

# (12) EUROPEAN PATENT SPECIFICATION

(45) Date of publication of patent specification :
09.09.92 Bulletin 92/37

(51) Int. Cl.⁵ : **H01L 21/90, H01L 21/28**

(21) Application number : **88909410.8**

(22) Date of filing : **23.09.88**

(86) International application number :
**PCT/US88/03271**

(87) International publication number :
**WO 89/03589 20.04.89 Gazette 89/09**

(54) INTEGRATED CIRCUIT CONTACT FABRICATION PROCESS.

(30) Priority : **08.10.87 US 107086**

(43) Date of publication of application :
**18.10.89 Bulletin 89/42**

(45) Publication of the grant of the patent :
**09.09.92 Bulletin 92/37**

(84) Designated Contracting States :
**DE GB NL**

(56) References cited :
**EP-A- 0 226 549
JOURNAL OF THE ELECTROCHEMICAL SOCI-
ETY, vol. 130, no. 9, September 1983, (Man-
chester, New Hampshire, US), R.M.LEVIN et
al.:"Oxide isolation for double polysilicon
VLSI devices", pages 1894-1897
EXTENDED ABSTRACTS, vol. 86-2, 19-24
October 1986, (Princeton, NJ, US), C.H.TING et
al.: "Spin-on-glass as a planarizingdielectric
layer for multilevel metallization", page 529,
abstract 352**

(73) Proprietor : **NCR INTERNATIONAL INC.
1700 South Patterson Boulevard
Dayton, Ohio 45479 (US)**

(72) Inventor : **MILLER, Gayle, Wilburn
140 Beckwith Drive
Colorado Springs, CO 80906 (US)**
Inventor : **CRAFTS, Harold, Springer
3243 Nelson Lane
Fort Collins, CO 80525 (US)**
Inventor : **MAHERAS, George
655 Zuni Circle
Fort Collins, CO 80526 (US)**
Inventor : **METZ, Werner, Adam, Jr.
57 Tea Street
Stoughton, MA 02072 (US)**
Inventor : **HAYWORTH, Hubert, Oscar
605 S. Meldrum
Fort Collins, CO 80521 (US)**

(74) Representative : **Robinson, Robert George
International Patent Department NCR Limited
206 Marylebone Road
London NW1 6LY (GB)**

EP 0 336 951 B1

## Description

### Technical Field

This invention relates to integrated circuit contact fabrication processes of the kind including the steps of: forming over an active region of a semiconductor substrate a first patterned electrode layer and an overlying first dielectric layer; forming in the active region and on said first dielectric layer a second electrode layer overlying at least an edge of said first electrode layer, to create a nonplanar step in the region of overlap with said first electrode layer; and forming a refractory metal based layer on said second electrode layer, said second electrode layer being patterned to retain the nonplanar step.

### Background Art

A process for integrated circuit contact fabrication is known from US-A-4,403,394 and is illustrated in Fig. I of the present drawings. As depicted in Fig. I, the prior art represents a portion of a DRAM cell formed in a lightly doped p-type monocrystalline substrate I, having an n+ conductively doped region 2 on one side of the active region and a doped polycrystalline silicon layer 3 (poly I) situated at the other side. The active region is bordered on the sides by field oxides 4. Poly I layer 3 is one electrode of a capacitor, which is selectively coupled to conductive region 2 upon the enablement of the field effect transistor formed by secondly deposited polysilicon gate electrode 6 (poly II) through a channel between region 2 and the substrate proximate electrode 3. An oxide dielectric 7 covers electrode 6. Connections between the poly II electrode layer 6 and subsequent metalization layers are made by contacts using metal 8, formed in known manner by masking and then etching openings through dielectric 7, depositing of a metal layer, and patterning the metalization. The known process has the disadvantage that the concluding contour is far from planar, and that the extent of overlapping between poly I capacitor electrode 3 and poly II gate electrode 6 must be significant to ensure that alignment tolerances do not result in a contact cut down to the level of the poly I layer by a misalignment of the contact cut mask over the edge of poly II layer. A relatively large contact area between metal 8 and poly II electrode 6 is also required to minimize the effects of contact resistance on the conduction of charge to poly II electrode 6.

The known process also has a disadvantage that the contact masking and etching steps are costly, and furthermore the area of the underlying polysilicon layer must be relatively large to compensate for alignment errors which are introduced by the successive masking operations.

From US-A-4,566,175, there is known a process for forming an access transistor for a one-transistor dynamic RAM cell wherein the gate of the transistor includes a layer of polysilicon and an overlying layer of molybdenum silicide.

### Disclosure of the Invention

It is an object of the present invention to provide an integrated circuit contact fabrication process of the kind specified, wherein the aforementioned disadvantages are alleviated.

Therefore, according to the present invention, there is provided an integrated circuit contact fabrication process of the kind specified in the opening paragraph of this description, characterized by the steps of: planarizing the structure with second dielectric to selectively expose the surface of the refractory metal based layer; and forming a patterned metalization layer over the second dielectric to make contact with the exposed surface of the refractory metal based layer.

Thus it will be appreciated that an integrated circuit contact fabrication process according to the present invention has the advantage of providing a self-aligned contact structure and the further advantages of not requiring masking or etching to form contact openings in a dielectric layer, reducing the polysilicon area allocation for mask alignment tolerances, minimizing metal step coverage problems, providing low ohmic resistance contact connections, and providing a degree of planarization for subsequent metalization layers.

In the context of connecting to a DRAM cell field effect access transistor gate electrode, the use of a contact fabrication process according to the invention reduces the "footprint" or area of the contact from the metalization layer to the second polysilicon gate electrode, and thereby measurably reduces undesired capacitive coupling between the gate electrode of the access transistor and the storage capacitor electrode.

### Brief Description of the Drawings

Embodiment of the present invention will now be described by way of example, with reference to the accompanying drawings, in which:-

Fig. I is a cross-sectional schematic of a DRAM fabricated according to the prior art.

Figs. 2 and 3 illustrate by way of schematic cross sections two embodiments of DRAM cells fabricated according to the present invention.

Figs. 4-9 schematically illustrate in the cross section representative stages in the fabrication sequence which concludes as the embodiment depicted in Fig. 2.

Best Mode for Carrying Out the Invention

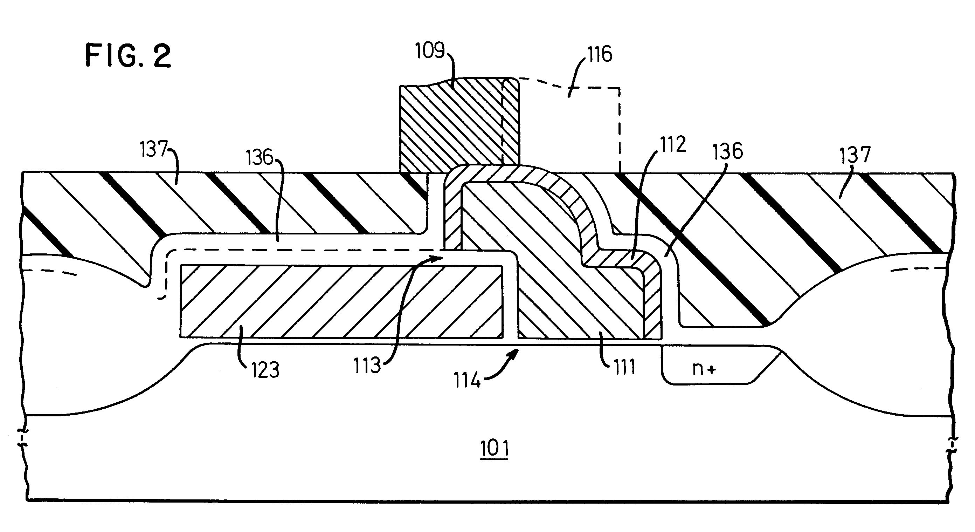

A structure fabricated according to the present invention is depicted in Fig. 2 of the drawings. The substantial planarity of the structures is immediately evident. Similarly visible is the minimal overlap between the poly I capacitor electrode 123 and the poly II gate electrode structures 111/112, namely in region 113. The compositely formed gate electrode, comprising poly II layer III and a selectively deposited refractory metal layers 112, provides a comparatively low resistance electrode structure. Note also that the contact between the poly II electrode and metalization 109, through intermediate dielectric, is self-aligned with relation to the edge of poly I electrode 123 by the nonplanar step at location 114. The presence of shunting refractory metal layer 112 minimizes contact resistance effects which might otherwise arise with a misalignment of the first metalization layer, such as that at 116, where direct metal-to-metal ensures acceptably low ohmic connection.

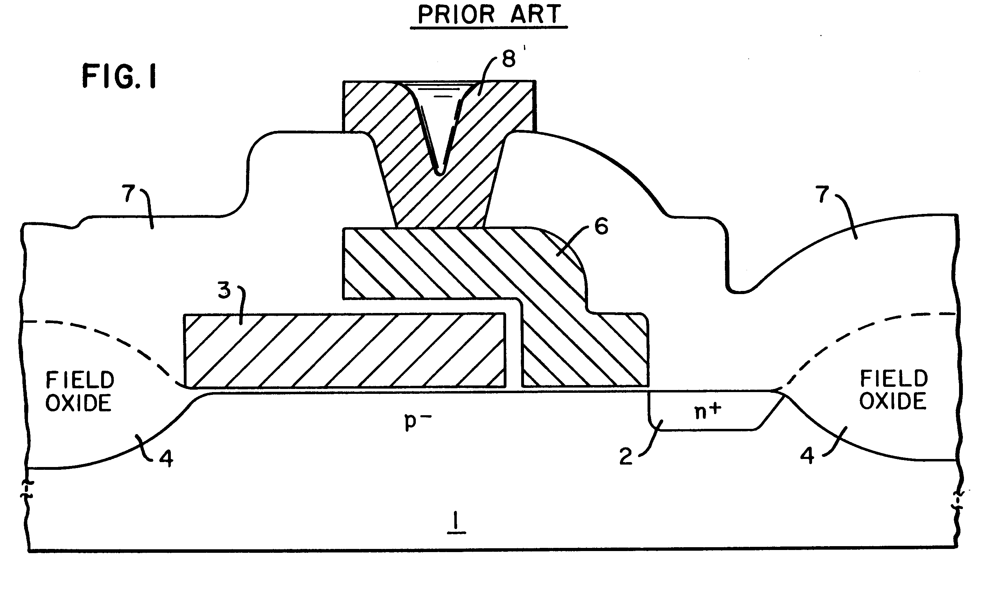

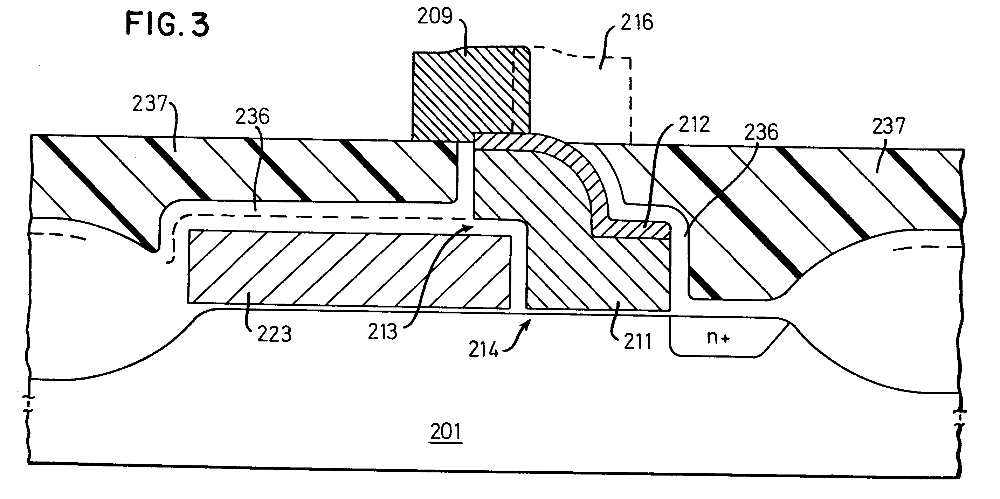

An alternative process according to the invention results in a structure schematically depicted in Fig. 3, wherein references denoting elements corresponding to those of Fig. 1 commence with the digit "2". The concluding structure has a shunting refractory metal layer 212 over the upper surface alone of poly II layer 211. Fabrication of the structure in Fig. 3 is believed to be somewhat easier, in that selective deposition of tungsten is not required. However, this variant requires the etching of successive tungsten and polysilicon layers during the formation of the electrode 211/212 pattern.

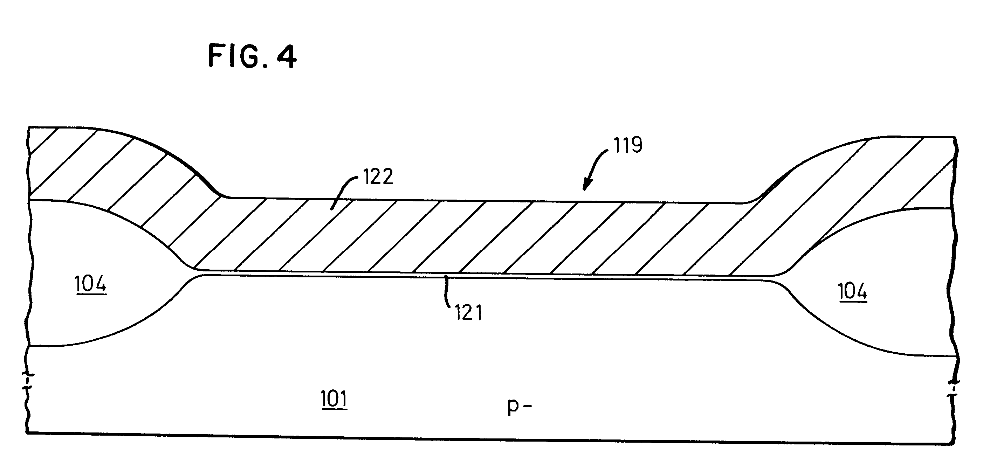

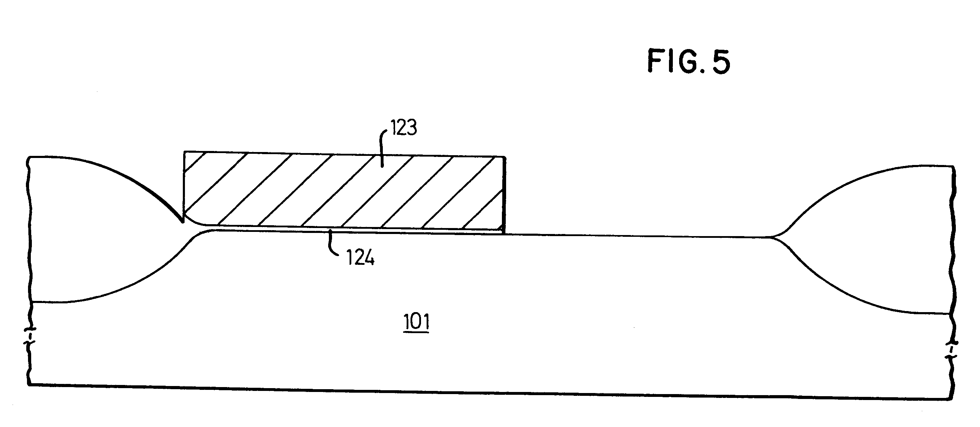

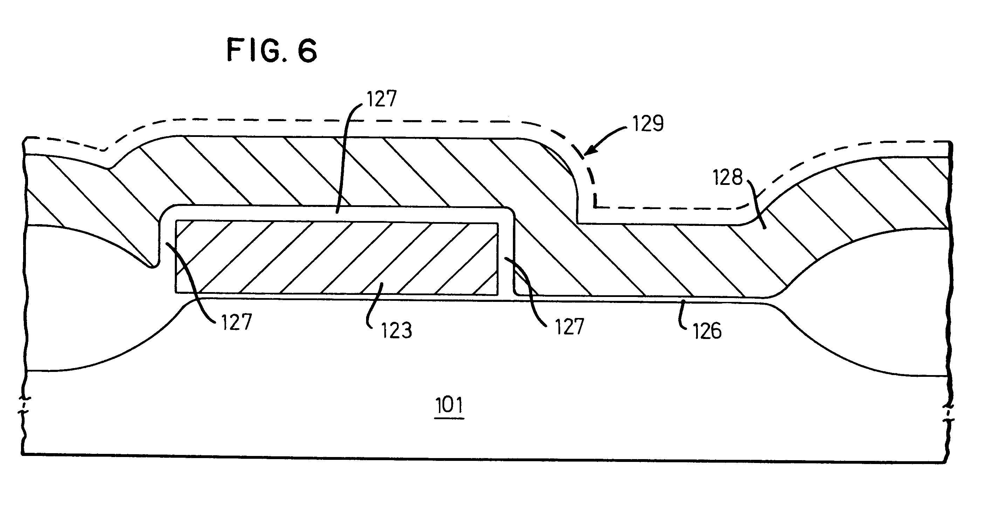

Practice of the invention according to the preferred embodiment begins with the structure schematically depicted in Fig. 4, where lightly doped p-type monocrystalline silicon substrate 101 is processed to create field oxide regions 104, and thereby define an active region 119 situated medially. The active region is thereafter covered by a thin oxide layer 121, preferably formed to a thickness of approximately 20 nanometers by thermal oxidation of the substrate 101, and a conductively doped polycrystalline silicon layer 122, poly I, deposited by known techniques to a thickness of approximately 500 nanometers. Poly I layer 122 and oxide 121 are then patterned by standard photoresist masking and etching techniques to create the structure depicted in Fig. 5, a capacitor electrode 123 electrically isolated from substrate 101 by an oxide dielectric 124. The patterned poly I layer 123 is then subjected to an oxidation operation suitable to form directly or in a sequence of multiple steps a dielectric suitable to isolate electrode 123 from any succeeding layers of conductive polysilicon. The thickness of the oxide dielectric immediately over substrate 101, designated as 126 in Fig. 6, is nominally 20 nanometers, while the dielectric layer 127 surrounding capacitor electrode 123 is nominally at least 70 nanometers. The difference in thickness is primarily attributable to the accentuated oxidation rate of doped polysilicon 123 over lightly doped monocrystalline silicon 101. The result is consistent with a preference for having a relatively thin gate oxide dielectric 126 while providing a relatively thicker interelectrode oxide dielectric 127.

As shown in Fig. 6, oxide regions 126 and 127 are covered in the next step of fabrication by a layer of doped polycrystalline silicon 128, poly II, which is in normal manner conformally deposited to the same nominal depth of approximately 500 nanometers as the Poly I layer 122. A feature of this deposition is the creation of step 129 in the contour of poly II layer 128, above the edge of poly I electrode layer 123. Step 129 is attributable to the difference in height between oxide layer 126 on one side and the combination of poly I layer 123 and somewhat thicker oxide layer 127 on the other side, whereby the step 129 is defined between first and second portions of the layer 128 which and respectively coplanar with, and overlying, the first electrode layer 123.

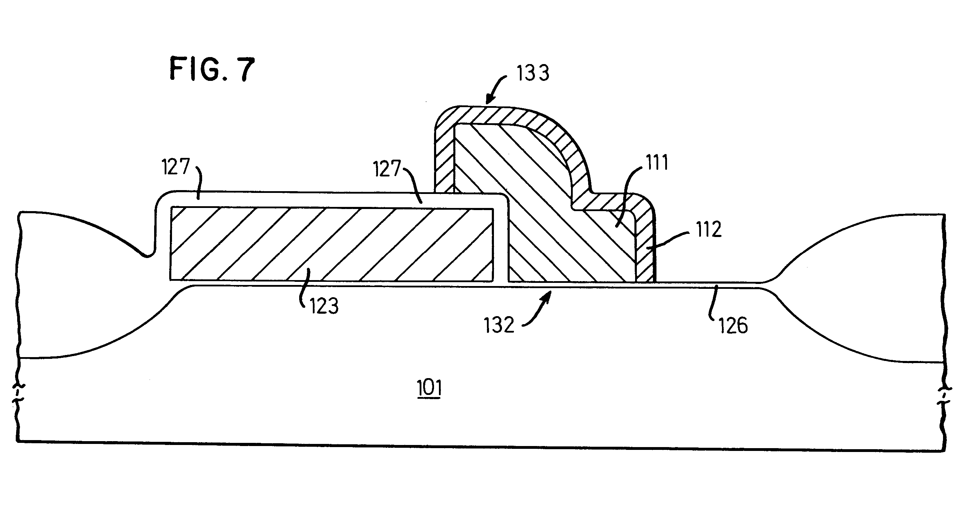

In progressing to the structure depicted in Fig. 7, the preferred embodiment includes masking and etching to retain a segment, electrode 111, of the poly II layer 128 over channel region 132, with a small elevated segment overlying poly I electrode 123 at location 133. The preferred practice of the invention next involves a selective deposition of a refractory metal layer 112, such as tungsten to a nominal thickness of 100 nanometers, onto any exposed silicon surface. Tungsten is preferred for its low resistance and high temperature capabilities. Nevertheless, other refractory metals or silicides thereof are also suitable shunting layers. The objective is to create low resistance shunting layers over the doped but relatively higher resistance polysilicon electrode 111.

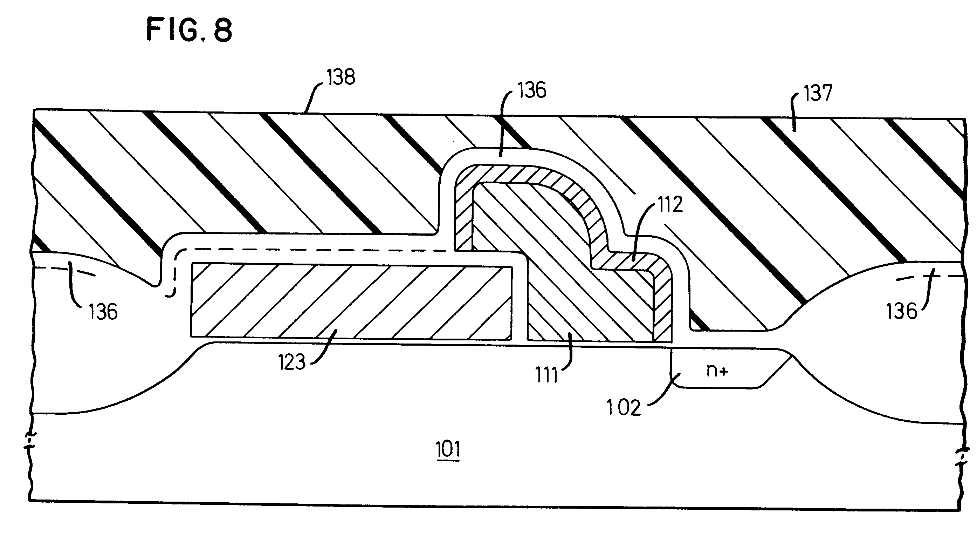

In keeping with a preferred practice of the invention and progressing towards the structure depicted in Fig. 8, the structure in Fig. 7 is next subjected to an ion implantation using phosphorus or the like to form $n^+$ doped region 102. Polysilicon layers 111 and 123 serve as implant masks to create the alignment between the edge of the poly II and tungsten gate electrode 111/112 and the doped region 102. Relatively thin gate oxide 126 does not materially impede the implant.

A slight variation of the preferred embodiment involves the performance of the implant which produces doped region 102 prior to the selective deposition of refractory metal layer 112. Again the poly I and poly II layers 123 and 111 would serve as self-align masks, and if so desired, could receive their impurity dose during such implant in lieu of being in situ doped during deposition. However, the desirability of doing so for poly I electrode 123 is materially less, in that this would reduce the differential oxidation rate used to create a thicker oxide layer 127 over that of 126, and could create an undoped region of poly I electrode 123 immediately under the edge of the poly II layer at 133.

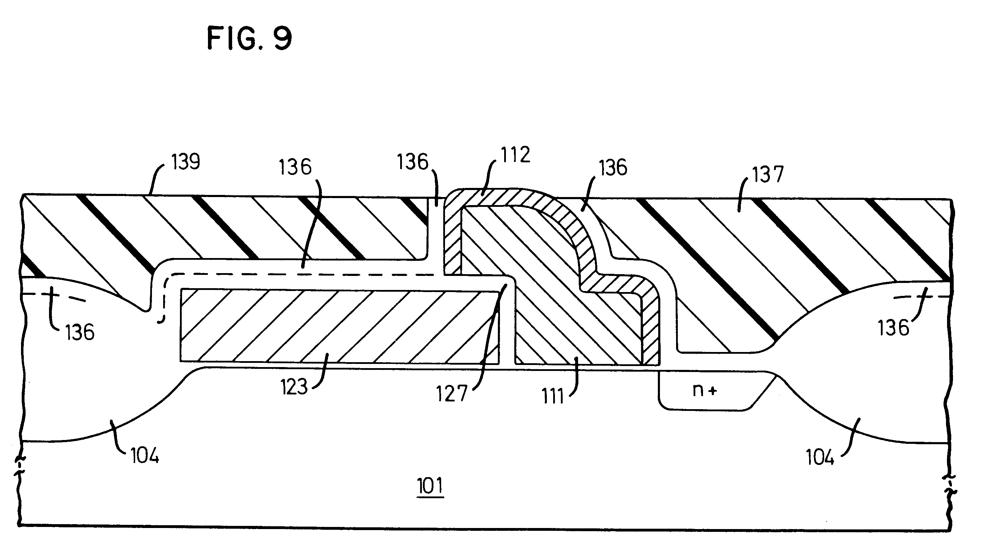

Following the implant to form doped region 102 and any desired implant annealing operations, the structure of Fig. 7 is preferably covered by approximately 1,000 nanometers of chemical vapor deposited (CVD) or plasma CVD oxide 136. The importance of having a high temperature refractory metal layer 112 becomes acutely evident with the use of plasma deposition. As is illustrated in Fig. 8, following the relatively conformal deposition of oxide layer 136, substrate 101 is covered with a relatively viscous planarization layer 137. Layer 137 is preferably a dielectric such as doped spin-on-glass (SOG) or polyimide, deposited in an amount and manner to form a relatively planar surface 138 over substrate 101. The planar character of surface 138 is then transferred down and into dielectric layer 136 by an isotropic etch of the composite structure using etchants which remove polyimide/SOG and dielectric 136 at substantially equal rates. A representative technique for such etching is described in US-A-4,604,I62. The I:I etch is continued until the surface of metal 112 is exposed. See Fig. 9. End point detection for the etch can be related to the presence of metal 112 in the etch residuals.

The attributes of the structure illustrated in Fig. 9 should be recognized. First, the poly I electrode 123 remains dielectrically isolated and substantially decoupled from overlying poly II/refractory metal electrode 111/112 by the presence of relatively thick oxide layer 127. Upper surface 139 of the substrate is substantially planar, and would likely have even greater planarity if the field oxide regions 104 were replaced with trench structures. Note that the exposed surface of metal 112 is aligned with the poly II electrode 111 and the edge of the poly I electrode 123, obviating the need for contact masking, etching and dimensional compensation.

The concluding structure in Fig. 2, as well as the alternate embodiment in Fig. 3, also aptly illustrate the inherent direct metal-to-metal contact between interconnect metalization 109, 209 and shunting metal layers 112/212. The low resistance of the metal-to-metal contact provides greater latitude in misalignment, yet provides a highly conductive shunt over the full extent of the poly II gate electrode.

## Claims

I. An integrated circuit contact fabrication process, including the steps of: forming over an active region of a semiconductor substrate (101,201) a first patterned electrode layer (123,223) and an overlying first dielectric layer (127); forming in the active region and on said first dielectric layer (127) a second electrode layer (111,211) overlying at least an edge of said first electrode layer (123, 223), to create a nonplanar step (129) in the region of overlap with said first electrode layer (123,223); and forming a refractory metal based layer (112,212) on said second electrode layer (111,211), said second electrode layer (111,211) being patterned to retain the nonplanar step, characterized by the steps of: planarizing the structure with second dielectric (136,137;236,237) to selectively expose the surface of the refractory metal based layer (112,212); and forming a patterned metalization layer (109,209) over the second dielectric (136,137; 236,237) to make contact with the exposed surface of the refractory metal based layer (112,212).

2. A process according to claim I; characterized in that said second electrode layer (111) is patterned prior to the formation of said refractory metal based layer (112); and in that said refractory metal based layer (112) is selectively deposited on said second electrode layer (111).

3. A process according to claim I, characterized in that said refractory metal based layer (212) is formed prior to the patterning of said second electrode layer (211); and in that patterning of said second electrode layer (211) includes a successive and substantially coextensive etch of said refractory metal based layer (212) and said second electrode layer (211).

4. A process according to claim I, characterized in that a first portion of said second electrode layer (111,112;211,212) is formed substantially coplanar with said first electrode layer (123,223) and a second portion of said second electrode layer (111,112;211, 212) in formed substantially over said first electrode layer (123,223), defining said step (129) between said first and second portions.

5. A process according to claim 4, characterized in that said planarizing step includes: forming successive layers of a conformal dielectric (136,236) and a viscous planarizing dielectric (137,237) to create a substantially planar surface; etching the surface to remove at substantially equal rates exposed conformal and viscous dielectric (136,137;236,237); and terminating the etch upon exposing the refractory metal based layer (112,212).

6. A process according to claim 5, characterized in that said second electrode layer (111,211) is conductively doped polycrystalline or amorphous silicon.

7. A process according to claim I, characterized in that said refractory metal is tungsten.

8. A process according to claim I, characterized in that said refractory metal is a tungsten rich silicide.

9. A process according to claim I, characterized in that said first and second electrode layers (123,111;223,211) are formed to approximately the same thickness.

## Patentansprüche

1. Ein Kontaktherstellungsverfahren für integrierte Schaltungen mit den Schritten: Bilden einer ersten strukturierten Elektrodenschicht (123, 223) und einer darüberliegenden ersten dielektrischen Schicht (127) über einem aktiven Bereich eines Halbleitersubstrats (101, 201); Bilden einer zweiten Elektrodenschicht (111, 211) in dem aktiven Bereich und auf der ersten dielektrischen Schicht (127) über zumindest einer Kante der ersten Elektrodenschicht (123, 223), um eine nichtplanare Stufe (129) in dem Bereich der Überlappung mit der ersten Elektrodenschicht (123, 223) zu formen; und Bilden einer Schicht (112, 212) basierend auf hitzebeständigem Metall auf der zweiten Elektrodenschicht (111, 211), wobei die zweite Elektrodenschicht (111, 211) derart strukturiert ist, daß sie die nichtplanare Stufe behält, gekennzeichnet durch die Schritte: Planarisieren der Struktur mit einem zweiten Dielektrikum (136, 137; 236, 237), um die Oberfläche der Schicht (112, 212) basierend auf hitzebeständigem Metall selektiv freizulegen; und Bilden einer strukturierten Metallisationsschicht (109, 209) über dem zweiten Dielektrikum (136, 137; 236; 237), um einen Kontakt mit der freigelegten Oberfläche der Schicht (112, 212) basierend auf dem hitzebeständigen Metall herzustellen.

2. Verfahren nach Anspruch 1, dadurch gekennzeichnet, daß die zweite Elektrodenschicht (111) vor der Bildung der Schicht basierend auf hitzebeständigem Metall strukturiert wird und daß die Schicht (112) basierend auf hitzebeständigem Metall selektiv auf der zweiten Elektrodenschicht (111) abgelagert wird.

3. Verfahren nach Anspruch 1, dadurch gekennzeichnet, daß die Schicht (212) basierend auf hitzebeständigem Metall vor der Strukturierung der zweiten Elektrodenschicht (211) gebildet wird und daß die Strukturierung der zweiten Elektrodenschicht (211) eine aufeinaderfolgende und im wesentlichen koexistente Ätzung der Schicht (212) basierend auf hitzebeständigem Metall und der zweiten Elektrodenschicht (211) einschließt.

4. Verfahren nach Anspruch 1, dadurch gekennzeichnet, daß ein erster Abschnitt der zweiten Elektrodenschicht (111, 112; 211, 212) im wesentlichen koplanar mit der ersten Elektrodenschicht (123, 223) und ein zweiter Abschnitt der zweiten Elektrodenschicht (111, 112; 211, 212) im wesentlichen über der ersten Elektrodenschicht (123, 223) gebildet werden, wobei die Stufe (129) zwischen dem ersten und zweiten Abschnitt definiert wird.

5. Verfahren nach Anspruch 4, dadurch gekennzeichnet, daß der Planarisierungsschritt umfaßt: Bilden aufeinanderfolgender Schichten eines konformen Dielektrikums (136, 236) und eines viskosen Planarisierungsdielektrikums (137, 237), um eine im wesentlichen planare Oberfläche zu formen; Ätzen der Oberfläche, um mit im wesentlichen gleichen Geschwindigkeiten konformes und viskoses Dielektrikum (136, 137; 236, 237) zu entfernen und Beenden der Ätzung bei Freilegen der Schicht (112, 212) basierend auf hitzebeständigem Metall.

6. Verfahren nach Anspruch 5, dadurch gekennzeichnet, daß die zweite Elektrodenschicht (111, 211) leitend dotiertes Polykristallin oder amorphes Silizium ist.

7. Verfahren nach Anspruch 1, dadurch gekennzeichnet, daß das hitzebeständige Metall Wolfram ist.

8. Verfahren nach Anspruch 1, dadurch gekennzeichnet, daß das hitzebeständige Metall ein wolframreiches Silizid ist.

9. Verfahren nach Anspruch 1, dadurch gekennzeichnet, daß die erste und zweite Elektrodenschicht (123, 111; 223, 211) mit annähernd der gleichen Dicke gebildet werden.

## Revendications

1. Procédé de fabrication d'un contact de circuit intégré, comprenant les étapes qui consistent : à former sur une région active d'un substrat semiconducteur (101, 201) une première couche d'électrode configurée (123, 223) et une première couche diélectrique (127) de recouvrement ; à former dans la région active et sur ladite première couche diélectrique (127) une seconde couche d'électrode (111, 211) recouvrant au moins un bord de ladite première couche d'électrode (123, 223) pour engendrer un gradin non plan (129) dans la région de recouvrement avec ladite première couche d'électrode (123, 223) ; et à former une couche (112, 212) à base de métal réfractaire sur ladite seconde couche d'électrode (111, 211), ladite seconde couche d'électrode (111, 211) étant configurée de façon à retenir le gradin non plan, caractérisé par les étapes qui consistent : à rendre plane la structure avec un second diélectrique (136, 137 ; 236, 237) pour exposer sélectivement la surface de la couche (112, 212) à base de métal réfractaire ; et à former une couche de métallisation configurée (109, 209) sur le second diélectrique (136, 137 ; 236, 237) pour établir un contact avec la surface exposée de la couche (112, 212) à base de métal réfractaire.

2. Procédé selon la revendication 1, caractérisé en ce que la seconde couche d'électrode (111) est configurée avant la formation de ladite couche (112) à base de métal réfractaire ; et en ce que ladite couche (112) à base de métal réfractaire est déposée sélectivement sur ladite seconde couche d'électrode (111).

3. Procédé selon la revendication 1, caractérisé en ce que ladite couche (212) à base de métal réfractaire est formée avant la configuration de ladite seconde couche d'électrode (211) ; et en ce que la configuration de ladite seconde couche d'électrode (211) comprend une gravure successive et sensiblement de même étendue de ladite couche (212) à base de métal réfractaire et de ladite seconde couche d'électrode (211).

4. Procédé selon la revendication 1, caractérisé en ce qu'une première partie de ladite seconde couche d'électrode (111, 112 ; 211, 212) est formée de façon à être sensiblement coplanaire avec ladite première couche d'électrode (123, 223) et une seconde partie de ladite seconde couche d'électrode (111, 112 ; 211, 212) est formée sensiblement au-dessus de ladite première couche d'électrode (123, 223) définissant ledit gradin (129) entre lesdites première et seconde parties.

5. Procédé selon la revendication 4, caractérisé en ce que ladite étape consistant à rendre plane consiste : à former des couches successives d'un diélectrique conforme (136, 236) et d'un diélectrique visqueux (137, 237) d'égalisation pour engendrer une surface sensiblement plane ; à graver la surface pour éliminer à des vitesses sensiblement égales les diélectriques conforme et visqueux exposés (136, 137 ; 236, 237) ; et à arrêter la gravure à la suite de l'exposition de la couche (112, 212) à base de métal réfractaire.

6. Procédé selon la revendication 5, caractérisé en ce que ladite seconde couche d'électrode (111, 211) est en silicium amorphe ou polycristallin à dopage conducteur.

7. Procédé selon la revendication 1, caractérisé en ce que ledit métal réfractaire est le tungstène.

8. Procédé selon la revendication 1, caractérisé en ce que ledit métal réfractaire est un siliciure riche en tungstène.

9. Procédé selon la revendication 1, caractérisé en ce que lesdites première et seconde couches d'électrode (123, 111 ; 223, 211) sont formées approximativement à la même épaisseur.

PRIOR ART

FIG.1

8'

7

6

3

7

FIELD
OXIDE

p−

n+

FIELD
OXIDE

4

2

4

1

EP 0 336 951 B1

# FIG. 2

EP 0 336 951 B1

# FIG. 3

EP 0 336 951 B1

FIG. 4

FIG. 5

EP 0 336 951 B1

# FIG. 6

# FIG. 7

EP 0 336 951 B1

# FIG. 8

138    136    137

112

136    123    111    112

102    n+

101

EP 0 336 951 B1

14

FIG. 9